# EUROPEAN PATENT APPLICATION

(11) **EP 1 113 214 A1**
(43) Date of publication of application: **04.07.2001**
(21) Application number: 99126125.6
(22) Date of filing: 28.12.1999
(51) Int. Cl.: F16P 3/14, H01L 21/00

(54) **Light curtain system for establishing a protective light curtain, tool and system for processing objects and method for loading/unloading a tool**

(71) Applicant: Infineon Technologies AG, 81669 München (DE); Semiconductor 300 GmbH & Co. KG, 01074 Dresden (DE); MOTOROLA, INC., Schaumburg, IL 60196 (US)
(72) Inventor: Lering, Michael, 09188 Bubenreuth (DE); Hahn, Sven, 01139 Dresden (DE); Schulz, Mathias, 01069 Dresden (DE)
(74) Representative: Zedlitz, Peter, Dipl.-Inf.

(57) **Abstract**

It is described a light curtain system (50) for establishing a protective light curtain (51) for a tool (40) in a system (20) for processing objects such as wafers, particularly as a safety device for an operator of said tool (40). Said light curtain system (50) comprises a first light curtain component (53) of invisible light beams (54), said invisible light beams (54) being emitted by an emitter (55) and being directed and transmitted in parallel to each other towards a receiver (56), said receiver (56) being adapted for receiving and detecting the presence or absence of said invisible light beams (54), said receiver (56) being located spaced apart from said emitter (55), said receiver (56) and emitter (55) forming edges (52) of said protective light curtain (51). In addition, a second light curtain component (57) of visible light beams (58) is provided, said visible light beams (58) being directed and transmitted adjacent and in parallel to said light beams (54) of invisible light for forming a part of said protective light curtain (51) and for making said protective light curtain (51) visible for an operator, said second light curtain component (57) of visible light beams (58) being activated at least temporarily.

## Description

The present invention generally relates to a light curtain system for establishing a protective light curtain for a tool. According to further aspects, the present invention relates to a tool and a system for processing objects, particularly for processing disklike objects such as wafers, flat panels, CDs or the like. According to yet another aspect, the present invention relates to a method for loading/unloading a tool with an object in a system for processing objects.

For example, such systems, tools and methods can be used in the process of manufacturing semiconductor products.

In the technical field of manufacturing and processing wafers (for example disks on the basis of silicon), flat panels or CDs in semiconductor industries it is common and necessary that such objects are frequently moved between different locations such as processing stations, metrology stations or the like. Moreover, there is a need to store said objects in specific storage areas, when they are not needed for the moment or before they are moved to a next station, respectively.

Usually, such objects are stored and processed under minienvironment conditions. In light of the present invention, the term minienvironment defines a localized environment created by an enclosure to isolate a product from contamination and/or people. The requirements for such minienvironments are set forth in document "Integrated Minienvironment Design Best Practices", international SEMATECH, Technology Transfer #99033693A-ENG, SEMATECH Technology Transfer, 2706 Montopolis Drive, Austin, TX 78741, USA, http://www.sematech.org for example.

During transportation and any processing and storage steps or conditions, those objects are usually stored in special containers, for example in socalled Front-Opening-Unified-Pods (FOUP).

In order to move such containers from one location to another location, they are usually carried by special vehicles which are moved along a system of tracks. Said system of tracks can be mounted at the ceiling of an environment or fabrication, thus forming a socalled Overhead-Hoist-Transport-System (OHT).

When the objects reach a desired station -for example a processing station, a loading station or the like- via said transport system, they are lowered from the ceiling towards said station, where subsequently a processing step is performed. After finishing the processing step, the objects are picked up by said transport system, lifted to the ceiling of said environment and moved away from said station.

However, delivering and storing objects or containers (FOUPS) to/at process and/or metrology tools or the like in an automated fashion requires many safety implications for operators and material. Particularly in fabrications or pilot lines which are not fully automated, the delivery process comprises both, automated steps -for example an automated transportation by an OHT-system- and manual delivery by the operators. To protect the operators from being injured by an OHT delivery to a tool, for example during lowering of objects from above operator's eye level, a safety housing is typically provided around the tool. To allow the automated loading as well as manual loading, the front of said safety housing is left open, thus forming a manual loadport. Said manual loadport is equipped with a safety feature, for example a protective light curtain or a similar device.

Todays light curtain systems comprise an emitter and a receiver for infrared light beams, thus forming a protective light curtain of infrared light beams. Typically, said light curtain is activated throughout the entire operation time. Under pretetermined circumstances, for exammple when an object is lowered toward or lifted from a station, an interruption of said invisible light beams by an opaque object, for example by the arm of an operator, may cause an action, for example an action to stop the tool or the transport system.

However, since the protective light curtain is invisible for an operator, the operator could accidentally interrupt said protective light curtain. Present light curtain systems do not provide any means to prevent that the protective light curtain might accidentally be interrupted.

From EP-A-0 598 630 a light curtain system is known, said light curtain system comprising a first light curtain component of invisible light beams, said invisible light beams being emitted by an emitter and being directed and transmitted in parallel to each other towards a receiver, said receiver being adapted for receiving and detecting the presence or absence of said invisible light beams, said receiver being located spaced apart from said emitter, said receiver and emitter forming edges of said protective light curtain. In case that one or more of said invisible light beams is/are blocked by penetration of an opaque object, such as the operator's arm or the like, a tool or system which is equipped with said light curtain system can be stopped.

The light curtain device as known from EP-A-0 598 630 further comprises a number of indicator lights emitting visible light. These indicator lights are mounted adjacent to the beams of invisible light. Furthermore, a control unit is provided. The control unit operates to sense when one or more invisible light beams are blocked by the intrusion of an opaque object. The control unit operates indicator lights which are located adjacet the blocked beams. The visible light provides a feedback to the operator, that and where the protective light curtain is interrupted.

However, all solutions as known from the prior art have several drawbacks. All solutions cannot prevent that an operator may accidentally interrupt said protective light curtain which is plainly invisible. The solution according to EP-A-0 598 630 only gives an indication, after the protective light curtain has been interrupted already.

For example, if those known solutions are used in the technical field of manufacturing and processing wafers as described above, an operator has no indication whether or not a loading operation is in progress. Therefore, he may accidentally interrupt said protective light curtain and thus trigger the action of stopping the manufacturing process.

Once, the conventional protective light curtain has triggered an emergency stop of the loading operation or tool operation, it takes precious time for the system to recover from this erroneous situation. The system has to be moved in slow motion back to its home position, the system state and teach points have to be rechecked and so on. This is very time consuming.

In view of the prior art it is an object of the present invention to provide a light curtain system for establishing a protective light curtain, a tool and a system for processing objects and a method for loading/unloading a tool, which overcome(s) the aforementioned drawbacks.

This object is solved by the light curtain system according to independent claim 1, the tool according to indepedent claim 13, the system accordig to independent claim 15 and the method according to independent claim 24. Further advantages, features, aspects and details of the invention are evident from the the dependent claims, the description and the accompanying drawings.

According to the first aspect of the present invention, a light curtain system for establishing a protective light curtain for a tool, particularly as a safety device for an operator of said tool, is provided, said light curtain system comprising a first light curtain component of invisible light beams, said invisible light beams being emitted by an emitter and being directed and transmitted in parallel to each other towards a receiver, said receiver being adapted for receiving and detecting the presence or absence of said invisible light beams, said receiver being located spaced apart from said emitter, said receiver and emitter forming edges of said protective light curtain. The light curtain system is characterized by the features that it further comprises a second light curtain component of visible light beams, said visible light beams being directed and transmitted adjacent and in parallel to said light beams of invisible light for forming a part of said protective light curtain, said second light curtain component of visible light beams being at least temporarily activated.

The light curtain system according to the present invention comprises as a first basic feature a first light curtain component, said component creating a protective light curtain consisting of invisible light beams. Additionally the light curtain system further comprises a second light curtain component of visible light beams. These visible light beams are directed and transmitted in such a manner that they run parallel to said invisible light beams and that they form a part of said protective light curtain. By use of said additional component of visible light beams the visual impression of a curtain is created.

From the existance of such visible light beams an operator will get an explicit hint, where the protective but invisible light curtain is positioned. Since the operator knows the exact location of said protective light curtain, it can be prevented that he accidentally interrupts said light curtain.

By enhancing a nonvisible light curtain by a visible light curtain element such actions can be avoided which otherwise would be triggered when the nonvisible curtain is interrupted -an emergency stop of a tool or of a transportation system for example.

Furthermore, the light curtain system according to the present invention can solve the problem of insufficient notification of operators, that a safety feature is active. Since the second light curtain component of visible light beams should be actived at least temporary, it can for example get activated only in such situations in which said safety feature is activated.

As mentioned above, in the field of manufacturing semocoductor products operators often may not be aware of an automated loading operation to an equipment loadport being in progress. A component of visible light beams in the protective light curtain could be activated, when such a loading operation is in progress. Thus, said component of visible light gives an easy and relatively inexpensive indication of such an operation in progress. The operator can see at one glance that manual access to the loadport currently is not allowed. An example for such an application is described with respect to the inventive tool, system and method below.

The improved light curtain system according to the present invention can be used as a safety feature for any kind of tools and in any kind of systems.

Preferably, control means can be provided, said control means being connected to said emitter and/or receiver for said invisible light beams and being adapted for processing signals received and detected by said receiver. Such control means can be either provided as independent elements or being integrated within said emitter and/or receiver. Such control means are necessary to check, whether an interruption of said protective light curtain has to trigger an action or not. This will be described in more detail with respect to the inventive system below.

In the same manner, other control means can be provided, said control means being connected to an emitter and/or a receiver for said visible light beams and being adapted for at least temporarily activating said second light curtain component of visible light beams.

Said emitter for said invisible light beams can comprise one or more light emittig diodes (LEDs). Advantageously, said receiver for said invisible light beams can comprise one or more light sensing elements, particularly one or more phototransistors, photoresistors or the like. However, the invention is not limited to any specific types of emitters or receivers.

Said invisible light beams can preferably be infrareed or near-infrared light beams.

Said second light curtain component can advantageously comprise an emitter for said visible light beams, said emitter advantageously comprising one or more light emitting diodes (LEDs) or one or more laser elements. The invention is not limited to specific types of emitters. Generally, any type of emitter can be used, which is capable of providing enough radiation energy to make the light visible under the prevailing environment conditions.

Said second light curtain component may further comprise a receiver for said visible light beams, said receiver advantageously comprising one or more light sensing elements or an arrangemet of mirrors.

Since the visible light curtain component only functions as a device for idicating the actual location of said protective light curtain, any type of emitter and/or receiver for said visible light beams can be used which is/are capable of directing the visible light in such a direction that it appears to be part of the protective light curtain.

Preferably, said visible light beams can have a frequency in the range of coloured light. In case that the invention is used in the field of semiconductor industries, the manufacture of such semiconductor products is usually performed in environments under clean room conditions. Under such conditions, said visible light beams can have a frequency in the range of yellow light or the like. Nevertheless, the present invention is not limited to special light-frequencies.

Advantageously, said emitter for said invisible light beams and/or said emitter for said visible light beams can be formed as an emitter-bar. According to another feature, said receiver for said invisible light beams and/or said receiver for said visible light beams can be formed as a receiver-bar. The formation in bar shape bears several advantages. As described above, said emitter(s) and/or receiver(s) form edges of said protective light curtain. By use of bar shaped elements the protective light curtain can -for example- be designed in rectangular shape, thus providing a unit which can easyly be mounted within the loadport of a tool for processing objects.

Said first light curtain component of invisible light beams can be adapted to function as an interruption sensor. Under these circumstances, when one ore more invisible light beams of said first light curtain component is/are blocked by an opaque object, for example by the arm of an operator, said interruption of light beams will be detected by the respective receiver. These signals are processed within said control means thus creating interruption signals, which can trigger an action to the tool or system equipped with said light curtain system. Such an action could be an emergency stop for example.

According to a second aspect of the present invention, a tool for processing objects, particularly for processing disklike objects such as wafers, flat panels, CDs or the like, is provided, said tool comprising a safety housing, said safety housing comprising at least one loadport for loading or unloading said tool with an object. At least one loadport is provided with a light curtain system according to the present invention as described above.

Thus, the at least one loadport is protected by a protective light curtain which, upon its second light curtain component of visible light beams creates the visual impression of a curtain. However, said -now visible- light curtain does not mechanically obstruct the loadport in said safety housing. For further aspects, details, effects and advantages of the tool according to the present invention it is also referred to the above description of the light curtain system according to the present invention.

A tool being equipped with such a light curtain system for establishing a protective light curtain increases the operator's safety, especially in case of automated material handling or delivery, since the active safety feature (the protective light curtain) is plainly visible. Based on said visible protective light curtain, disadvantageous tool downtimes due to failed delivery operations by accidental light curtain interruptions can be minimized. Since the protective light curtain now has been made visible, the training procedures for the operators can be simplified.

The use of a tool having such a light curtain system could lead to an immense cost reduction.

The invention is not limited to specific kinds of objects which can be processed by said tools. Preferably, all sorts of objects can be processed, which have to be held under minienvironment or clean room conditions. The term "minienvironment" has already been explained in the introducory part of the description. Advantageously, the tool is used to process disklike objects such as wafers, for example wafers with a diameter up to and beyond 300mm, flat panels or CDs.

Also, the ivention is not limited to specific kinds of tools. For example, the invention can be applied to every tool that is run in an automatic delivery mode such as an automated OHT delivery mode, because the operator interference represents a permanent risk with these tools.

In the light of the present invention, the term "tool" can comprise a processing tool and/or a metrologoy tool and/or a storage tool or the like. Furthermore, the term "tool" can also comprise any load station for one of the aforementioned tools. The ivention is not limited to these specific examples.

According to a third aspect of the present invention, a system for processing objects, particularly for processing disklike objects such as wafers, flat panels, CDs or the like is provided, said system comprising an arrangement for moving said objects through an environment, said system further comprising one or more tools as described above for processing said objects, at least one of said tools comprising a light curtain system as described above for establishing a protective light curtain for said tool.

In such a system, an operator will be prevented from accidentally interrupting a protective light curtain. Additionally, the operator can get an indication, when an automated loading/unloading operation with regard to a tool of said system is in progress. For further details, effects, advantages, aspects and for the function of said system it is also referred to the above described light curtain system as well as to the tool according to the present invention.

According to the system of the present invention, said second light curtain component of visible light is at least temporarily activated. This will be described with respect to a non limiting example. Said second light curtain component can be activated just before a predetermined situation occurs and/or during such a situation. In case that a tool shall be delivered with an object to be processed, for example by aid of an Overhead-Hoist-Transportation system, said component of visible light beams can be activated, when the system is in progress to load the tool with the object, that is when said object is on its way to said tool. Such a situation, which is about 10%-80% of the entire processig time, is a dangerous situation for a tool-operator, since he usually is not aware of an automated loading operation to said tool, said operation being normally in progress above the operator's eye level.

In such a situation, if the second light curtain component is activated, the operator gets a clear and direct indication that an object is on its way to the tool. During this time period he can stay away from said tool. For this reason, the possibility of getting injured is minimized.

Furthermore, the operator is prevented from accidentally interrupting said protective light curtain. Such an interruption could trigger the disadvantageous action of an emergency stop of said system. Once, the system has triggered such an emergency stop it would take a lot of time to recover the system, for example to move the transport system back to its home position, to recheck the state and the teaching points of said system and so on. The proposed invention can safe this time while maintaining the protective features of such solutions as known in the prior art.

Advantageously, said control means being connected to said emitter and/or receiver for said invisible light beams can also be adapted for processing signals received from said arrangement for moving objects. In a similar manner, said control means being connected to said emitter and/or receiver for said visible light beams can also be adapted for processing signals received from said arrangement for moving objects. This enables the safety features of the system, for example the first light curtain component of invisible light beams and the second light curtain component of visible light beams to get activated with respect to the actual location of an object which has to be delivered to a tool by aid if said arrangement for moving objects. If said object approaches to said tool, the arrangement will transmit its actual local position to said control means, which activate said safety features based on these signals.

The second light curtain component remains activated during the processig procedure within said tool and until said operation has been finished. Then, the visible light component is deactivated again. Now the operator has manual access to the tool without any risk.

Advantageously, said arrangement for moving objects can be formed as an Overhead-Hoist-Transport (OHT) system. Such a system can preferably be used in the field of semiconductor manufacturing. As evident from the term "overhead", said system is mounted at the ceiling of an environment or a fabrication.

Such an OHT-system may comprise a system of tracks, said tracks being advantageously arranged at the ceiling of said environment. Preferably, two or more tracks are provided, said tracks forming said system of tracks.

Preferably, said arrangement for moving objects may comprise one or more vehicles for trasporting said objects to be moved.

By use of a system of tracks, the vehicle(s) can be moved very easy to any desired location within said environment. In case of a semiconductor fabrication for example, said vehicle(s) can be easily moved to a tool such as a processing station, a metrology station, a storage area, a loading station or the like. Advantageously, the system of tracks may be comprised of one or more branching points.

According to the present invention, there is no need for a system of tracks with only one special configuration. The system of tracks can be adapted to the environment, for example the fabrication, wherein it is installed. The different tracks are arranged in such a manner that every desired location can be reached by said vehicle(s) carrying an object. Therefore, the system of tracks may comprise one or more of the above branching points, which connect the different tracks to become said system of tracks. In this case, the different tracks function as a sort of branches which lead to different locations. The number and configuration of said tracks and said branching points depends on the respective requirements.

The present invention is not limited to a specific number of vehicles, which can be moved through the environment along said tracks. In its basic configuration, the system according to the present invention can comprise at least one vehicle. However, it is also possible to use two or more vehicles.

When more than one vehicle is used, the system of tracks may be comprised of one or more bypass-tracks. The purpose of such bypass-tracks is to move two or more different vehicles past one another. In this case, the required number of tracks for moving more than one vehicle at the same time can be minimized.

Advantageously, said track or tracks is/are formed as an overhead track or overhead tracks. In this case, the track or tracks are preferably mounted at the ceiling of the environment. Therefore, the objects carried by the vehicle(s) of said system can be moved above the operators working in said fabrication and the different processing locations and units. Thus, no obstructions with respect to the transportation of the objects betweeen different locations can arise.

Preferably, said arrangement for moving objects can be adapted for moving containers, said containers storing said objects to be moved. Advantageously, said containers can be minienvironment containers, particularly Front-Opening-Unified-Pods (FOUP). For example, such a container is definded in SEMI-Standards E44 ans E62, the contents thereof are incorporated into the description of the present invention by reference with respect to the FOUPs. The containers can also be designed according to SEMI-Standard E47.1, the content of which is also incorporated by reference into the description of the present invention.

Advantageously, said system can be adapted for processing wafers with a diameter up to 300mm or beyond.

Furthermore, said environment can have clean room conditions. Nevertheless, the invention can also be used in dirtier environments, especially, when objects, containers and tools with minienvironment conditions are used.

According to a fourth aspect of the present invention, a method for loading/unloading a tool -as described above- with objects in a system for processig objects -as described above- is provided, said method comprising the steps of generating a first set of invisible light beams by aid of said first light curtain component to establish a protective light curtain in the area of the loadport of said tool, and, in predetermined situations, generating at least temporarily a second set of visible light beams by aid of said second light curtain component, said visible light beams being directed and transmitted adjacent and in parallel to said invisible light beams for forming a part of said protective light curtain, thus making said protective light curtain visible for an operator.

By use of said method, an operator will be prevented from accidentally interrupting a protective light curtain. Additionally, the operator can get a clear and direct indication, when an automated loading/unloading operation to a tool of said system is in progress. For further details, effects, advantages, aspects and for the function of said method it is also referred to the above described light curtain system as well as to the tool and the system according to the present invention.

Preferably, said second light curtain component can be activated when an object is delivered to the tool and/or processed at the tool and/or moved away from said tool. Advantageously, said second light curtain component can be activated when an object is lowered to the tool or lifted from the tool by aid of said arrangement for moving objects.

Said second light curtain component can be deactivated, when the object is moved away from said tool.

Said first light curtain component is activated preferably throughout the entire operation time of said system, whereby those signals received and detected by the receiver of said first light curtain component and being processed by said control means only trigger an action, if a predetermined situation arises, advantageously if an object is delivered to a tool and/or processed at the tool and/or moved away from said tool.

With the present invention both product and operator safety will be improved. At the same time, the danger of product loss can be reduced.

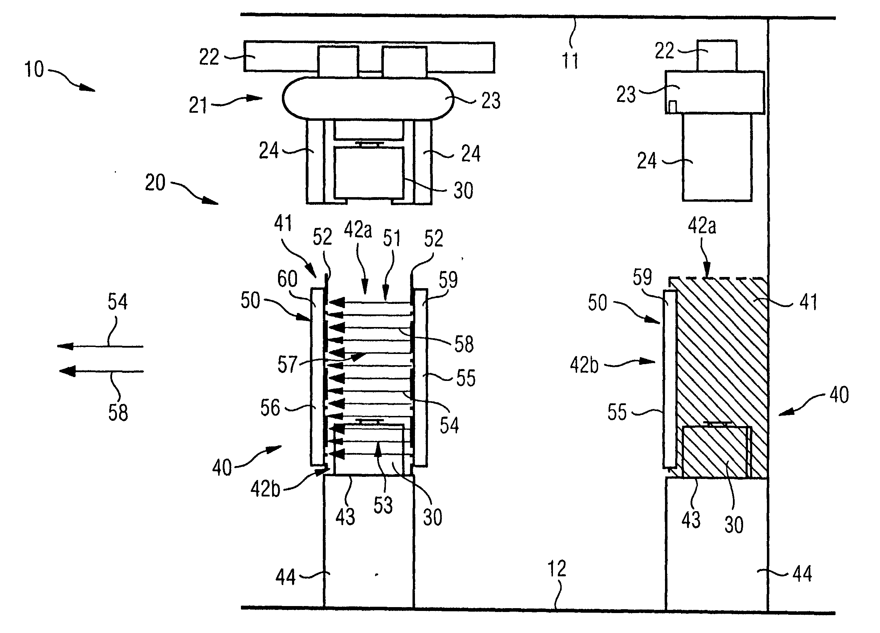

The invention will be better understood by reference to the following description of an embodiment of the invention taken in conjunction with the accompanying drawings, wherein Figure 1 shows a schematic view of a system for processing objects accordimg to the present invention.

In Figure 1, a system 10 for processing objects is illustrated, said system 10 being used in an environment 10 or fabrication for manufacturing semiconductor products such as wafers with a diameter up to 300mm or beyond, flat panels, CDs or the like. The environment 10 is held under clean room conditions.

System 20 comprises an arrangement 21 for moving objects, which is -in the present embodiment- formed as an Overhead-Hoist-Transportation (OHT) system. OHT-system 21 is mounted at the ceiling 11 of said environment 10. The attachment of OHT-System 21 at ceiling 11 can be accomplished in a known manner. Therefore, this attachment is not described in detail in the present embodiment.

OHT-system 21 comprises a system of tracks 22, along which vehicles 23 can be moved. In the present embodiment, two vehicles 23 are illustrated.The system of tracks 22 can be formed in a maner which enables the vehicles 23 to be moved to any desired location within said environment 10.

In the present embodiment, vehicle 23 comprises gripping devices 24 which are capable of holding containers 30 for storing objects. These containers 30 can be formed as so called Front-Opening-Unified-Pods (FOUPs). Within such a container 30, a number of disklike objects can be stored.

Containers 30 are moved along said system of tracks 22 through environment 10 to different tools 40. In Figure 1, only two tools 40 are illustrated. However, the invention is not limited to a special number of tools 40. For example, said tools 40 can be formed as processing tools, wherein said objects stored in said containers 30 are processed, as metrology tools, as storage tools for storing said objects or containers 30 and the like. Said tools 40 can also be formed as so called loading stations for one of the aforementioned tools 40.

In the present embodiment according to Figure 1, both tools 40 function as loading stations. Each loeading station 40 comprises a tool body 44, said tool body 44 being attached to the floor 12 of environment 10. Furthermore, each loading station 40 is equipped with a support area 43 for storing containers 30. Each loading station 40 is surrounded by a safety housing 41 to protect an operator from being injured ant to protect those stored containers 30 from being damaged.

Each loading station 40 comprises two loadports 42a,b. One loadport 42a is provided at the top end of safety housing 41 thus enabling the OHT-system 21 to deliver a container 30 to said loading station 40 by lowering said container 30 from the top (from ceiling 11) towards said support area 43 of loading station 40. A second loadport 42b is provided in a wall of safety housing 41. Said loadport 42b is arranged in the area of an operator's eye level. Said loadport 42b allows manual access to said loading station 40 by the operator.

Said loadport 42b is protected by a light curtain system 50. Said light curtain system 50 is adapted for establishing a protective light curtain 51 for tool 40, particularly as a safety device for the operator of said tool 40. Said light curtain system 50 comprisig a first light curtain component 53 of invisible light beams 54, particularly infrared light beams.

Said invisible light beams 54 are emitted by an emitter 55, which is formed as an emitter-bar having a number of light emitting diodes (LEDs). Those emitted invisible light beams 54 are directed and transmitted in parallel to each other towards a receiver 56, said receiver 56 being adapted for receiving and detecting the presence or absence of said invisible light beams 54. In the present embodiment, receiver 56 is formed as a receiver-bar consisting of a number of phototransistors or photoresistors.

Receiver 56 is located spaced apart from emitter 55, said receiver 56 and emitter 55 forming edges 52 of said protective light curtain 51.

Said invisible light beams 54 created by said first light curtain component 53 create an invisible barrier, which can, if activated upon blocking one or more beams 54, trigger a predetermined action.

Light curtain system 50 further comprises a second light curtain component 57 of visible light beams 58 -in the present embodiment with a frequency in the range of yellow light-, said visible light beams 58 being directed and transmitted adjacent and in parallel to said light beams 54 of invisible light. Thus, visible light beams 58 form a part of said protective light curtain 51, thereby making said protective light curtain 51 visible for an operator. Said second light curtain component 57 of visible light beams 58 is activated at least temporarily.

Those visible light beams 58 are created by an emitter 59, which is formed as an emitter-bar including a number of light emitting elements such as light emitting diodes (LEDs), laser elements or the like. Emitter 59 is arranged with respect to emitter 56 in such a manner, that those visible light beams 58 which create the visual impression of a curtain, can indicate the actual location of those invisible light beams 54. Therefore, emitter 59 can for example be arranged in parallel to emitter 56 or in such a manner, that invisible and visible light beams are emitted alternately with respect to each other. For an easier understanding, emitters 55 and 58 are indicated as a common blackened element in Figure 1.

Second light curtain component 57 further comrises a receiver 60 for said visible light beams, said receiver 60 being arranged with regard to receiver 56 in similar manner as described in view of the aforementioned emitters 55, 59. Since receiver 60 only has to ensure that visible light beams 58 are transmitted in parallel to invisible light beams 54 and since said visible light beams 58 do not have any function with respect to activate or control actions of system 20, receiver 60 could be comprised of an arrangement of mirrors.

In the following, a method for loading/unloading containers 30 in said system 20 of processing objects is described. When starting system 20, the first light curtain component 53 of invisible light beams 54 is activated, said component 53 remaining activated troughout the entire operation time of system 20. However, an interruption of one or more beams 54 by an opaque object such as the arm of an operator will only trigger an action, if a predetermined situation arises.

For example, a control means being connected to said emitter 55 and/or said receiver 56 can also be connected to OHT-system 21. In case that a container 30 is in progress to be delivered to a tool 40 by vehicle 23, a respective signal from OHT-system 21 can be transmitted to control means. If now an interruption of one or more invisible light beams 54 occurs, a predetermined action can be triggered, for example an emergency stop of tool 40 and/or of OHT-system 21. In this case, the operator can be protected from injuries. In case, that no container 30 is in progress to be loaded or unloaded to/from loading station 40, the interruption of one or more invisible light beams 54 will cause no reaction of system 20.

Since the protective part of protective light curtain 51 is formed of invisible light beams 54, an operator is not able to recognize the actual local position of said protective curtain 51. Therefore, he could accidentally interrupt one or more of said invisible light beams in case that a loading operation is in progress. This could easily occur, since the OHT-delivery operation usually takes place above operator's eye level.

In order to overcome said drawbacks, said second component 57 of visible light beams 58 is added to the light curtain component 53 of invisible light beams 54. Said second light curtain component 57 is only activated, when a predetermined situation occurs. This could be a situation, when an automated loading operation is in progress. When the object reaches the tool at which it shall be processed, the second light curtain component 57 of visible light beams 58 is activated. Therfore, an operator of said tool 40 can see at one glance, if a loading/unloading operation is active and if a manual access to said tool is not permitted. After the operation at tool 40 has been finished, second light curtain component 57 is deactivated again and the operator has allowed manual access to tool 40.

## Claims

1. A light curtain system for establishing a protective light curtain (51) for a tool (40), particularly as a safety device for an operator of said tool ((40), said light curtain system (50) comprising a first light curtain component (53) of invisible light beams (54), said invisible light beams (54) being emitted by an emitter (55) and being directed and transmitted in parallel to each other towards a receiver (56), said receiver (56) being adapted for receiving and detecting the presence or absence of said invisible light beams (54), said receiver (56) being located spaced apart from said emitter (55), said receiver (56) and emitter (55) forming edges (52) of said protective light curtain (51),
**characterized in**
that said light curtain system (50) further comprises a second light curtain component (57) of visible light beams (58), said visible light beams (58) being directed and transmitted adjacent and in parallel to said light beams (54) of invisible light for forming a part of said protective light curtain (51), said second light curtain component (57) of visible light beams (58) being activated at least temporarily.

2. The light curtain system according to claim 1,
**characterized in**
that control means are provided, said control means being connected to said emitter (55) and/or receiver (56) for said invisible light beams (54) and being adapted for processing signals received and detected by said receiver (56).

3. The light curtain system according to claim 1 or 2,
**characterized in**
that control means are provided, said control means being connected to an emitter (59) and/or a receiver (60) for said visible light beams (54) and being adapted for at least temporarily activating said second light curtain component of visible light beams (58).

4. The light curtain system according to anyone of claims 1 to 3, **characterized in**
that said emitter (55) for said invisible light beams (54) comprises one or more light emittig diodes (LEDs).

5. The light curtain system according to anyone of claims 1 to 4, **characterized in**
that said receiver (56) for said invisible light beams (54) comprises one or more light sensing elements, particularly one or more phototransistors or photoresistors.

6. The light curtain system according to anyone of claims 1 to 5, **characterized in**
that said invisible light beams (54) are infrared or near-infrared light beams.

7. The light curtain system according to anyone of claims 1 to 6, **characterized in**
that said second light curtain component (57) comprises an emitter (59) for said visible light beams (58), said emitter (59) advantageously comprising one or more light emitting diodes (LEDs) or one or more laser elements.

8. The light curtain system according to anyone of claims 1 to 7, **characterized in**
that said second light curtain component (57) comprises a receiver (60) for said visible light beams (58), said receiver (60) advantageously comprising one or more light sensing elements or an arrangemet of mirrors.

9. The light curtain system according to anyone of claims 1 to 8, **characterized in**
that said visible light beams (58) have a frequency in the range of coloured light.

10. The light curtain system according to anyone of claims 1 to 9, **characterized in**
that said emitter (55) for said invisible light beams (54) and/or said emitter (59) for said visible light beams (58) is formed as an emitter-bar.

11. The light curtain system according to anyone of claims 1 to 10, **characterized in**
that said receiver (56) for said invisible light beams (54) and/or said receiver (60) for said visible light beams (58) is formed as a receiver-bar.

12. The light curtain system according to anyone of claims 1 to 11, **characterized in**
that said first light curtain component (53) of invisible light beams (54) is adapted to function as an interruption sensor.

13. Tool for processing objects, particularly for processing disklike objects such as wafers, flat panels, CDs or the like, said tool (40) comprising a safety housing (41), said safety housing (41) comprising at least one loadport (42) for loading or unloading said tool (40) with an object,
**characterized in**
that at least one loadport (42) is provided with a light curtain system (50) according to anyone of claims 1 to 12.

14. The tool according to claim 13,
characterized in
that said tool (40) is formed as a processing tool and/or a metrology tool and/or a storage tool and/or a loading station for one of the aforementioned tools.

15. System for processing objects, particularly for processing disklike objects such as wafers, flat panels, CDs or the like, said system (20) comprising an arrangement (21) for moving said objects through an environment (10), said system (20) further comprising one or more tools (40) according to claim 13 or 14 for processing said objects, at least one of said tools (40) comprising a light curtain system (50) according to anyone of claims 1 to 12 for establishing a protective light curtain (51) for said tool (40).

16. The system according to claim 15,
**characterized in**
that said control means being connected to said emitter (55) and/or receiver (56) for said invisible light beams (54) is also adapted for processing signals received from said arrangement (21) for moving objects.

17. The system according to claim 15 or 16,
**characterized in**
that said control means being connected to said emitter (59) and/or receiver (60) for said visible light beams (58) is also adapted for processing signals received from said arrangement (21) for moving objects.

18. The system according to anyone of claims 15 to 17,
**characterized in**
that said arrangement (21) for moving objects is formed as an Overhead-Hoist-Transport (OHT) system.

19. The system according to claim 18,
**characterized in**
that said OHT-system (21) comprises a system of tracks (22), said tracks (22) being advantageously arranged at the ceiling (11) of said environment (10).

20. The system according to anyone of claims 15 to 19,
**characterized in**
that said arrangement (21) for moving objects comprises one or more vehicles (23) for transporting said objects to be moved.

21. The system according to anyone of claims 15 to 20,
**characterized in**
that said arrangement (21) for moving objects is adapted for moving containers (30), said containers (30) storig said objects to be moved.

22. The system according to anyone of claims 15 to 21,
**characterized in**
that said system (20) is adapted for processing wafers with a diameter up to 300mm or beyond.

23. The system according to anyone of claims 15 to 22,
**characterized in**
that said environment (10) has clean room conditions.

24. Method for loading/unloading a tool according to one of claims 13 or 14 with an object in a system for processing objects according to anyone of claims 15 to 23, said method comprising the steps of generating a first set of invisible light beams by aid of said first light curtain component to establish a protective light curtain in the area of the loadport of said tool, and, in predetermined situations, generating at least temporarily a second set of visible light beams by aid of said second light curtain component, said visible light beams being directed and transmitted adjacent and in parallel to said invisible light beams for forming a part of said protective light curtain, thus making said protective light curtain visible for an operator.

25. The method accordig to claim 24,
**characterized in**
that said second light curtain component is activated when an object is delivered to the tool and/or processed at the tool and/or moved away from said tool.

26. The method accordig to claim 24 or 25,
**characterized in**
that said second light curtain component is activated when an object is lowered to the tool or lifted from the tool by aid of said arrangement for moving objects.

27. The method accordig to anyone of claims 24 to 26,
**characterized in**
that said second light curtain component is deactivated, when the object is moved away from said tool.

28. The method accordig to anyone of claims 24 to 27,
**characterized in**
that said first light curtain component is activated throughout the entire operation time of said system and that those signals received and detected by the receiver of said first light curtain component and being processed by said control means only trigger an action, if a predetermined situation arises, advantageously if an object is delivered to a tool and/or processed at the tool and/or moved away from said tool.
